# EUROPEAN PATENT APPLICATION

(11) **EP 0 558 305 A2**
(43) Date of publication of application: **01.09.1993**
(21) Application number: 93301382.3
(22) Date of filing: 24.02.1993
(51) Int. Cl.: H05K 7/18

(54) **Apparatus and method for the supply of power and/or data with shelving systems**

(30) Priority: 24.02.1992 GB 9203918; 25.02.1992 GB 9204124
(71) Applicant: CLARES-REGISBROOK SYSTEMS LIMITED, Wells, Somerset BA5 1UT (GB)
(72) Inventor: Liddle, Alan, Woodcote, Reading RG8 0PX (GB)
(74) Representative: Perkins, Sarah

(57) **Abstract**

Apparatus for supplying power and/or data to electronic label devices 17 mounted on shelves 4 of a shelving system includes a connector 19 which is mountable in a slot provided in the hollow support 1 of the shelving system. The connector 19 is electrically connected to at least one electronic label device 17 and is also connected to a supply of power and/or data through the interior of the support 1. In this way the electronic label devices 17 may be mounted on an existing shelving system without the necessity of the majority of items stored on the shelving being moved. In addition, the exposed cabling for connecting the electronic label devices 17 to the power and/or data is minimised thus providing a safer and more aesthetically pleasing shelving system.

## Description

The present invention is directed to apparatus and a method for the supply of power and/or data with shelving systems, for use for example, in supermarkets and warehouses where items are stored and/or displayed on shelving of hollow construction and information regarding the items including the price is displayed on electronic label devices located on the shelving. The present invention is particularly but not exclusively for use with electronic shelf edge displays.

In recent years there has been substantial developments in the use of electronic label devices in both supermarket and warehouse environments. Whilst some electronic label devices are completely "free-standing", being, for example, battery-operated and linked to a central computer by direct radio communication, many label devices require at least some form of local wiring to supply control signals from a local receiver unit, which is effectively a node in the whole computer network. The receiver unit may itself be either hard-wired to, or in some form of wire-less communication with, the central control computer. The wiring to the label devices needs to be installed in such a manner that, as far as possible, it does not intrude on valuable shelf space and, for safety and aesthetic reasons, it is not easily accessible or visible to customers.

One known method of connecting the electronic label devices to a power and data supply is by running cables from the electronic label devices along the shelving to a back panel of the shelving system and then along the back panel up to a power and data supply provided at the top edge of the shelving system. This method has the disadvantage that where the electronic label devices are to be mounted on existing shelving systems, the connection of the electronic label devices is particularly disruptive because it requires items on the shelving to be removed in order to position the cables along the back panels of the shelving system. Logistically it will rarely be practical to remove all the stock from the shelving, and it is also undesirable to have to substantially dismantle the shelving structures. These problems are particularly acute for the many large supermarkets which are open for extended hours, often seven days a week.

The present invention arose, at least in part, from a consideration of the aforementioned problems, and aims to provide convenient and secure installation of electronic label devices fitted to both new and existing shelving.

It is to be noted that, as used herein, the term "wiring" is to be taken to include the use, for example, of rigid bus bar-like conductors and of optical fibres in addition to or in place of conventional electrical cables.

In a first aspect the present invention provides connection apparatus for connecting a power and/or data supply to one or more electrically operable label devices mounted on a shelving system, the connection apparatus being adapted for mounting on a hollow support member of the shelving system to supply power and/or data to the one or more electrically operable label devices through one or more slots provided in the hollow support member.

Thus, with the present invention power and/or data may be supplied to the electrically operable label devices in a simple and convenient manner on established shelving systems without the necessity of removing all the items stored on the shelving.

The connection apparatus may comprise a first part which is fitted inside the hollow support member and a second part which is adapted to engage the first part and is fitted outside the hollow support member. There may be means for securing the two parts together.

There may be respective connection apparatus for each shelf. In this case, the first part may include a portion which projects through a slot in the hollow support member and is engaged by a portion of the second part of complementary shape. Each first part may be connected to a respective cable housed within the hollow support member which carries the power and/or data.

Alternatively, the first part of the connection apparatus may be common to a number of the shelves mounted on a hollow support member. In this case, the first part may be a track having substantially rigid conductors or bus bars which carry power and/or data and the second part may have a portion which is a push-fit into a slot of the hollow support member and has contacts for making connection with the rigid conductors. If the hollow support member is adapted to have shelves mounted on opposing sides thereof, two such tracks may be formed as an integral component.

In a further embodiment the connection apparatus may include a first transceiver having supply connection means for connection to a data supply for transmitting and receiving data along the interior of the hollow support member of the shelving system, wherein the interior of the hollow support member functions as a wave guide; and one or more label connection means for connection to the more or electrically operable label devices, each label connection means having a label transceiver mounted on a portion of the label connection means adapted for insertion into the interior of the hollow support member through a slot provided in the hollow support member.

In a further aspect of the present invention, in a shelving system in which shelves are mounted on hollow support members which have a plurality of slots for the removable attachment of shelf-mounting brackets, and in which electrically operable label devices are mounted on said shelves, there is provided connection apparatus adapted to be fitted to said hollow support members to supply power and/or data to said electrically operable label devices through slots unused by said brackets.

The present invention further provides a method for supplying power and/or data from a supply to one or more electrically operable label devices mounted on a shelving system wherein the power and/or data is supplied by means of a hollow support member of the shelving system to the one or more electrically operable label devices through one or more slots provides in the hollow support member.

In a preferred embodiment, the power and/or data is supplied within the interior of the hollow support member by means of one or more conductors extending the length of the hollow support member and located within the interior of the hollow support member and the one or more electrically operable label devices are connected to said one or more conductors by means of connectors which are brought into electrical contact with the one or more conductors when the connectors are inserted through slots in the hollow support member.

In an alternative preferred embodiment, data is supplied within the interior of the hollow support member by utilizing the interior of the hollow support member as a wave guide and providing a transceiver at one end of the hollow support member for receiving and supplying the data to said one or more electrically operable label devices by means of cooperable transceivers located on connectors which may be inserted into the interior of the hollow support member by insertion into slots provided in the hollow support member.

In accordance with a further aspect of the invention, in a shelving system in which shelves are mounted on hollow support members which have a plurality of slots for the removable attachment of shelf-mounting brackets, and in which electrically operable label devices are mounted on said shelves and linked by wiring to a local control unit, a method of installing wiring to said electrically operable label devices comprising the steps of disposing within the hollow support members means for supplying power and/or data to the electrically operable label devices, and making connections between said means for supplying said power and/or said data and said electrically operable label devices through slots in said hollow support members which are unused by said shelf-mounting brackets.

The present invention is also directed to a shelving system having connection apparatus as described above.

Embodiments of the invention will now be described, by way of example only, with reference to the accompanying drawings, in which:
Figures 1 to 3 show basic features of known types of shelving systems;
Figure 4 is a schematic elevation which shows, in accordance with a first embodiment of the present invention, the installation of wiring to electronic shelf labels in the shelving systems of Figures 1 to 3;
Figure 5 is a schematic part-sectional view of the shelving system shown in Figure 4;
Figure 6 shows details of a connector arrangement used in the first embodiment of the present invention shown in Figures 4 and 5; and
Figures 7, 8 and 9 show details of connector arrangements used in a further embodiment of the present invention.

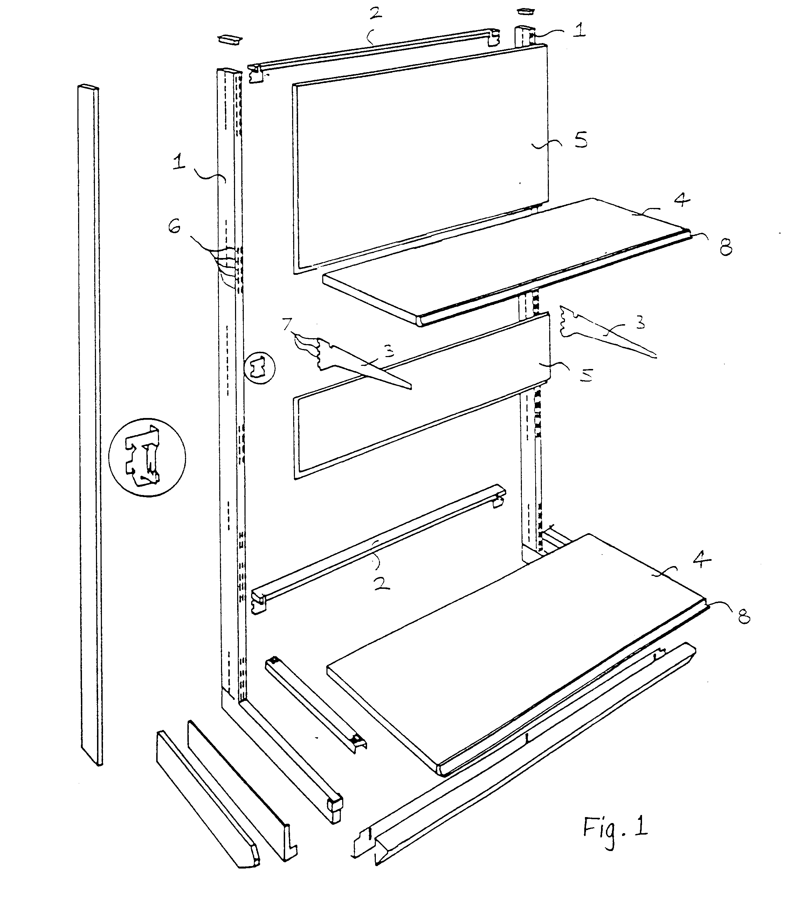

Referring to the drawings, Figure 1 shows the basic structure of one known type of shelving unit. The important components for present purposes are two vertical supports 1, horizontal members 2, shelf-mounting brackets 3, shelves 4 and back panels 5. The supports 1, known as keybars, comprise hollow metal tubing of rectangular section, in which a plurality of longitudinally arranged slots 6 are formed on the front edges, as shown. The supports 1 are linked horizontally by the members 2, known as tie rails, to provide a rigid frame structure. The shelves 4 are seated on brackets 3 which are removably attachable to the supports 1 by means of hooks 7 which engage the slots 6 in well-known manner. The slots may be formed along the whole length of the supports or may be provided in only selected areas of the supports. Thus, the brackets can be fitted in any of a large number of positions according to the number and spacing of the shelves required. A plurality of back panels 5 are also provided between the supports 1. The back panels 5 are adapted for mutual engagement along their horizontal edges so as to form a continuous back wall for the unit. On the projecting outer edge of each shelf 4, there is mounted an elongate moulding 8 which accomodates strip-like labels carrying price and other information about the goods. When electronic shelf-edge label devices are fitted these may be mounted in the existing label-carrying mouldings. Alternatively, the electronic label devices may be adapted to fit directly onto the shelf edge.

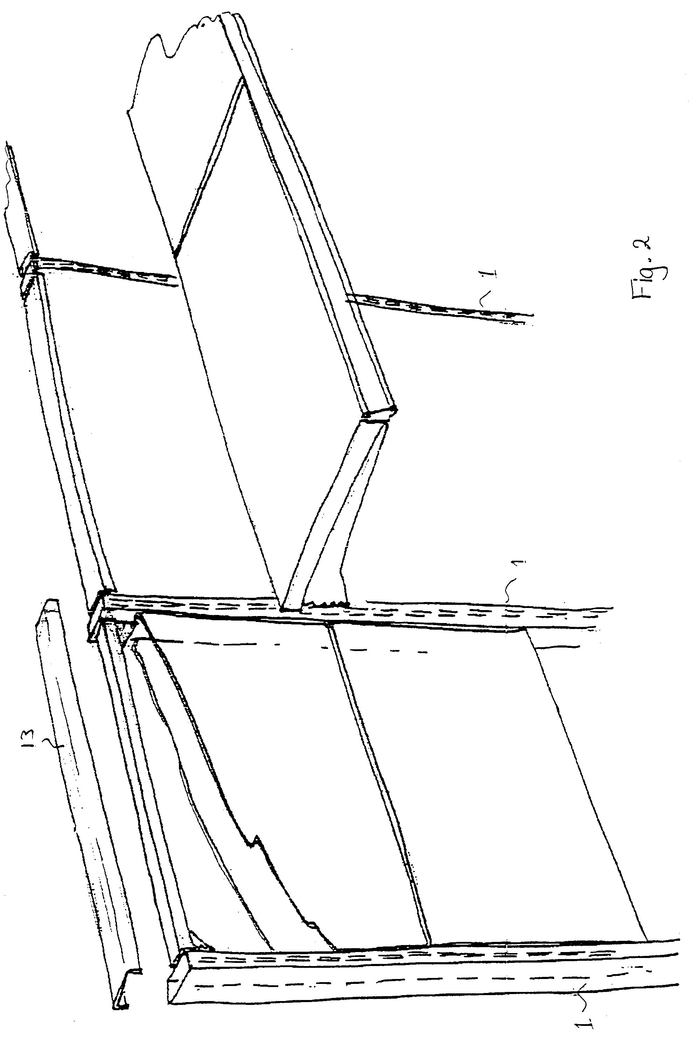

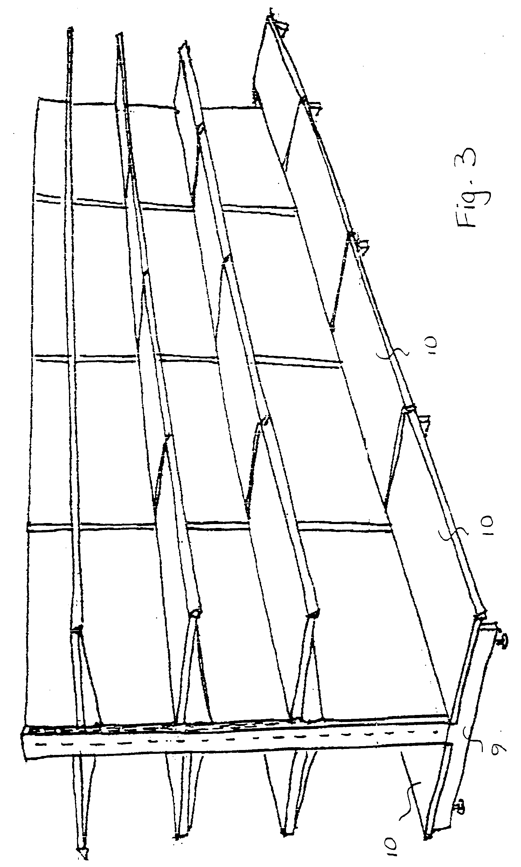

Generally, a number of shelf units of the type shown in Figure 1 are used in combination to provided long rows of shelving, as shown, for example, in Figures 2 and 3. As can be seen in Figure 2 the keybar supports 1 are shared by adjacent shelf units. For this purpose the supports have two adjacent lines of slots along the front edge. In Figure 3, supports 1 carry shelving on opposing sides of the shelf units by means of slots provided in the two narrower sides of the rectangular tubing. The supports in this structure are each provided with a horizontal base member 9 which sits on the floor. The lower shelves 10 are seated on these base members.

As mentioned earlier, when electronic shelf labels are to be fitted to shelving systems such as those described above, they will generally need to be wired to a local control unit/receiver which is in communication with the central control computer. The local control unit may be housed at any convenient location within the shelving system, for example, behind the back panels 5 (Figure 1) or underneath the floor-level shelves 10 (Figure 3). If the control unit is to be hard-wired to the central computer, then its optimum location may be dictated by existing cable trunking which supplies, for example, power to shelf lighting and/or for refrigeration units. If this existing cabling is provided from the floor, then a location in the base of the shelving units may be preferred. Alternatively, if the existing cabling is provided from the ceiling, the control unit may be conveniently located behind one of the uppermost back panels and supported, for example, from one of the tie rail members 2.

A large variety of different electronic label devices for use with shelving systems have been developed in recent years most of which include a liquid crystal display and also which may display other printed information and a bar code. An electronic device and the means of its attachment to a shelf edge is described and claimed in International patent application No. PCT/GB92/00152 the contents of which is incorporated herein by reference.

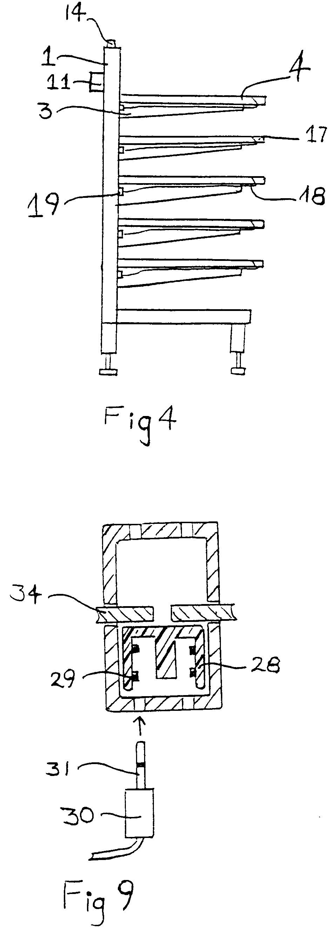

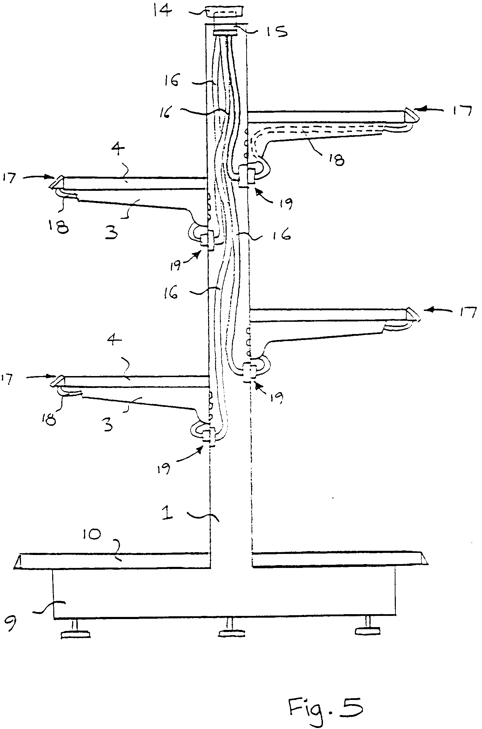

Figures 4 and 5 show wiring between a local control unit and electronic label devices mounted on the shelf edges. In this example, the local control unit 11 is mounted towards the top of one shelf unit, behind one of the upper back panels. However, the actual location of the control unit 11 is not of particular significance. Hard-wiring to the control unit 11 from the central computer is not shown.

The output from the control unit 11 carrying power and/or control or data signals for the electronic label devices, is provided on a ribbon cable (not shown). The ribbon cable is disposed along the top of the shelf units, for example, attached to the upper tie bars 2. It may be enclosed by a top cap 13 (see Figure 2) which fits over the top of each shelf unit. The ribbon cable includes a plurality of in-line connectors whose locations are arranged to coincide with the positions of some or all of the supports 1. Each of the in-line connectors 14 is adapted to receive a number of plug insert connectors 15 to enable power and control signals on the ribbon cable 12 to be supplied to a number of ribbon cables 16 within each support 1. As will now be explained with reference to Figure 5, which is an end-on sectional view of one shelving unit, the cables 16 enable the supply of power and control signals from the control unit 11 to the electronic label devices fitted to the shelves.

Referring to Figure 5, in which the back panels 5 have been omitted for clarity, electronic label devices 17 are fitted to the outer edges of the shelves 4. In practice, the devices would also be fitted to the floor-level shelves 10, but they are not shown here for simplicity. A control cable 18 from each label device 17 is located away beneath the shelf as shown by the dotted lines behind the upper right-hand bracket in Figure 5. It is expected that there will be only one control cable 18 from the label device or devices on each shelf, but it will be appreciated that more than one control cable per shelf could none the less be accomodated if necessary. In practise, the control cable 18 may be secured to the underside of the shelf by adhesive or some form of cable clip, and would not be as visible or accessible as is shown in the drawings. Connection between the control cable 18 and the supply cable 16 within the support 1 is achieved by using a two part connector 19. The two parts of the connector 19 are fitted together through one of the slots 6 (see Figure 1) in the support 1 which is unused by the shelf-mounting brackets 3. It is envisaged that in practise a vacant slot immediately below the bracket would be used so as to keep the control cables 18 as short as possible and to prevent them encroaching on the shelf storage space.

It can be seen that, by using the key bar supports of the shelf units to provide trunking for wiring, the shelf labels may be fitted and wired to the local control unit, without the need to remove large qauntities of stock from the shelves or to dismantle the shelving structure altogether. The supply cable 16 can be conveniently fed into the supports 1 from the top and to the internal part of each connector 19 located and pushed out through the appropriate slot by means, for example, of a rod which is adapted to hold the connector part and can be manipulated from the top of the support. Fitting of the connectors in sequence from the bottom of the support up is likely to be preferred in practice. The electronic label device 17 can be fitted and the control cables 18 connected by means of the outer part of the connector 19 without removing goods from the shelves. Whilst to wire up labels on the floor-level shelves 10 may require these shelves to be cleared, many shelving units have as many as five or six other rows of shelves on either side of the supports which would not need to be cleared. Thus, it will be apparent that a very considerable saving in wiring installation time can be obtained.

Whereas in this embodiment the use of a common feed cable 12 running along the top of the shelving units, and "tapped" at each support, is envisaged, it will be appreciated that this is not essential. There may, for example, be individual cables from the control unit 11, either to each support or to each connector 19. In the latter case, the in-line connectors 14 and tap connectors 15 could be dispensed with.

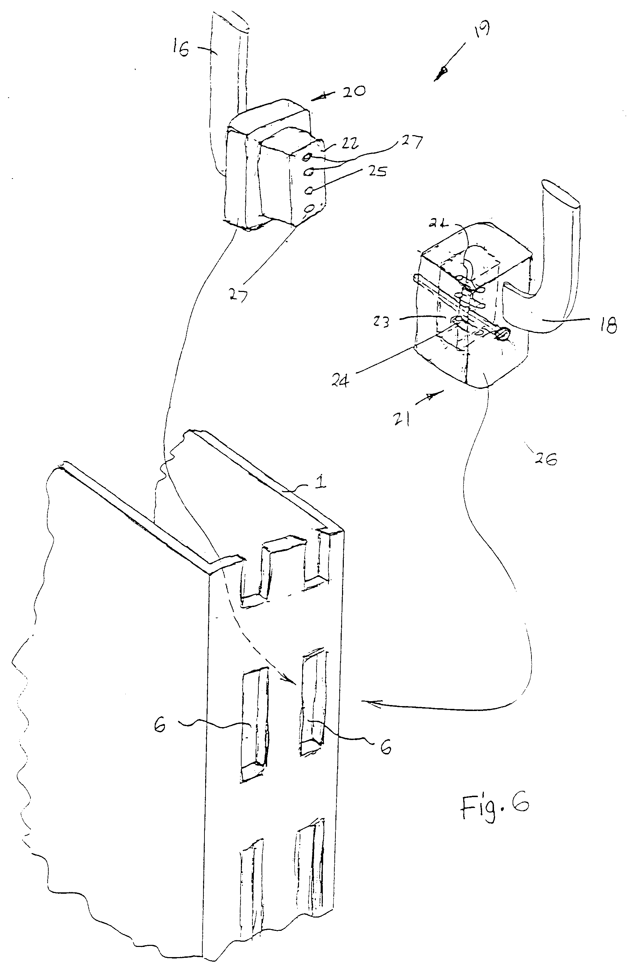

Figure 6 shows details of a connector 19 suitable for use with the connection apparatus described above. The connector 19 comprises a first part 20 which is fitted inside the support 1 and a second part 21 which is fitted outside the support 1. The supply cable 16 is terminated in the first part 20. The control cable 18 is terminated in the second part 21. The internal part 20 of the connector has a male portion 22 which fits securely within the slot 6 in the support to project outwardly therefrom. The male portion 22 carries three electrical contact sockets 27. (It is assumed here, for the purposes of the illustration only, that the cables 12, 16 and 18 comprise three wires but, of course, there may be any number to suit the requirements of the particular label devices used.) The external part 21 of the connector has a female portion which comprises a recess 23 in which the male portion fits in a mating fashion. The recess 23 carries three contact pins 24 which marry up with the sockets 27 in the part 20 when the two parts of the connector are brought together to establish the necessary electrical connections between the cables 16 and 18.

The two parts 20, 21 may be secured together by means, for example, of a bolt 26 in the external part 21, which is screwed into a threaded bore 25 in male portion 22 of the internal part 20. In addition, to ensure the continuity of the connection, the use of the bolt 26 may assist in bringing the two parts 20, 21 together initially, reducing the risk of the internal part 20 being punched into the support 1 and out of the locating slot 6.

Figure 7 illustrates, in a section through the support 1, a connector 19 for use in an alternative connection apparatus. Here, the internal part 20 of the connector of Figure 6 is replaced by a track 28 of, for example, moulded plastic. The track 28 runs along the length of the support 1, behind the slots 6, and provides rigid conductors 29 to which connection can be made by means of a plug 30 inserted through any vacant slot in the support 1. Thus, the track 28 also replaces and dispenses with the need for the supply cable 16 and the earlier apparatus. In the example shown in Figure 7, the conductors 29 are held in recesses in the back wall of the track 28. Pins 31 provided on the end of the plug 30 are located in the recesses to engage the conductors 29. As in the earlier apparatus, the plug 30 may be secured to the track 28 by means of a bolt or screw (not shown). Alternatively, the plug and the track may be designed such that, after insertion of the plug 30 into the slot 6, a twisting action applied to the plug simultaneously locks it in place and establishes electrical contact.

The spacing d of the rear wall of the track 28 from the slot 6 must, of course, be sufficient to provide clearance for the bracket hooks 7. It will be appreciated that the conductors are not essentially provided on the rear wall of the track 28. Thus, the conductors may be provided on one of the side walls or, alternatively, distributed between two or all three of the track walls.

The track 28 may be formed in longitudinal sections which are connected together by, for example, a snap fit. This arrangement will assist the insertion of the track into the supports of the shelving system which is already assembled and in use, since the available space at the top end of the support may be restricted. This alternative apparatus has the particularly useful advantage of permitting the shelves in a unit to be re-arranged, since the plug 30 may be inserted into a vacant slot without the need to make any changes to connector parts housed within the support.

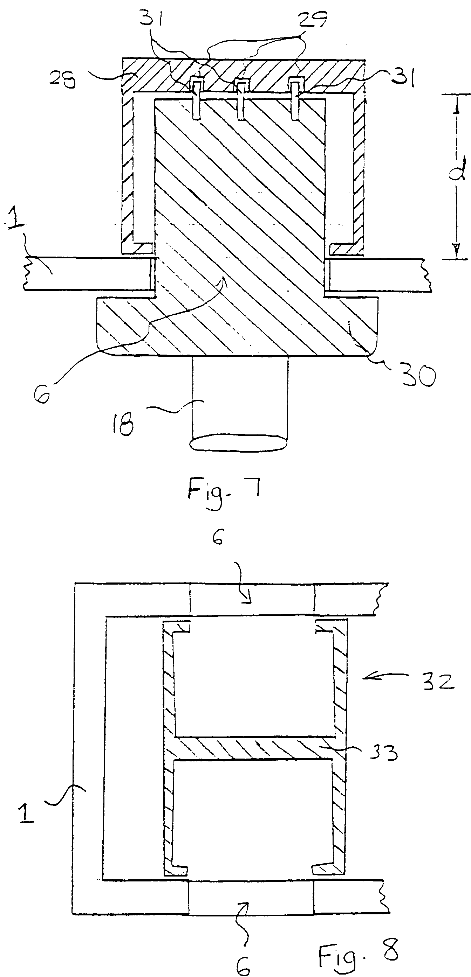

In shelving units of the type shown in Figure 3, ie. having shelves on two sides, two tracks may be fitted in each support. These tracks may comprise an integral moulding 32, as shown in Figure 8. This back-to-back track arrangement also serves to securely locate the tracks within the support. If the conductors are carried by the common wall 33, a single set of conductors will suffice to supply power and control signals to both sides of the support 1.

Turning now to Figure 9, one track 28 is shown, however, it will be understood that two opposing tracks may be mounted in the support 1. The track 28 is self-locating in the support 1 and in order to hold the track 28 in position within the support 1, wing members 34 forming a part of the support 1 project through slots provided in the side walls of the support 1. The portion of the wing members 34 which are located within the support 1 act as abutment surfaces which are engaged by the track 28. As may be seen in Figure 9 the conductors or bus bars 29 are located on side walls of the track 28 and two sets of conductors 29 are shown in Figure 9 corresponding to the two rows of slots provided in the support 1 where shelves are to be mounted to either side of the support 1. Biasing means in the form of springs may also be used to correctly locate and hold the tracks in position within the support.

Alternatively, separate means may be provided to supply only data to the electronic label devices 17. A transceiver (not shown) which is located as the top of the support 1 and is connected to a data supply transmits the data to a transceiver mounted on the internal part 20 of the connector 19. Similarly, the transceiver mounted on the connector 19 may transmit an acknowledgement or separate data which is received by the tranceiver mounted at the top of the support 1. With this apparatus the interior of the support 1 acts as a wave guide. The transceivers may be infra-red or radio frequency (RF) tranceivers. The connector 19 has the transceiver mounted on an end portion of the connector 19 which is inserted through any vacant slot 6 into the interior of the support 1. The support 1 which is metallic provides a multiple reflection environment which ensures that all the transceivers inserted into the support 1 on connectors 19 are communicated with.

In an alternative embodiment, power is supplied to the electronic label devices 17 in the manners described with reference to Figures 4 to 9 whereas data is supplied using the transceivers described above. With this arrangement two separate connectors 19 are required to supply each of the electronic label devices 17 with power and data separately.

It will be apparent that the wiring arrangements described herein are not limited to use in the fitting of electronic shelf labels. For example, they may be used to connect up shelf lighting.

It will be appreciated that the connection arrangements and shelving systems described and illustrated herein may be varied in many obvious ways, and that such variations are not to be regarded as a departure from the scope of the invention. Also, there may be novel features of the systems described which are independently inventive.

## Claims

1. Connection apparatus for connecting a power and/or data supply to one or more electrically operable label devices (17) mounted on a shelving system, the connection apparatus being adapted for mounting on a hollow support member (1) of the shelving system to supply power and/or data to the one or more electrically operable label devices (17) through one or more slots (6) provided in the hollow support member (1).

2. Connection apparatus as claimed in claim 1, wherein the connection apparatus has a first part (20) adapted to be fitted inside the hollow support member (1) and a second part (21) adapted to engage the first part (20) and to be mounted on the shelving system outside the hollow support member (1).

3. Connection apparatus as claimed in claim 2, wherein respective connection apparatus is provided for each shelf (4) of the shelving system and each first part (20) is connected to a respective cable (16) housed within the hollow support member (1), each of the respective cables (16) also being connected to said power and/or data supply.

4. Connection apparatus as claimed in claim 2, wherein the first part (20) is in the form of one or more substantially rigid conductors (29) housed within the hollow support member (1), the one or more rigid conductors (29) being connected at one end to the power and/or data supply and the second part (21) having a portion (31) adapted for insertion into a slot (6) of the hollow support member (1) and for engagement with the one or more rigid conductors (29).

5. Connection apparatus as claimed in claim 1, wherein the connection apparatus includes a first transceiver having supply connection means for connection to a data supply for transmitting and receiving data along the interior of the hollow support member (1) of the shelving system, and one or more label connection means for connection to the one or more electrically operable label devices (17), each label connection means having a label transceiver mounted on a portion of the label connection means adapted for insertion into the interior of the hollow support member (1) through a slot (6) provided in the hollow support member (1).

6. A method for supplying power and/or data from a supply to one or more electrically operable label devices (17) mounted on a shelving system wherein the power and/or data is supplied by means of a hollow support member (1) of the shelving system to the one or more electrically operable label devices (17) through one or more slots (6) provided in the hollow support member (1).

7. A method as claimed in claim 6, wherein the power and/or data is supplied within the interior of the hollow support member (1) by means of one or more conductors (29) extending the length of the hollow support member (1) and located within the interior of the hollow support member (1) and the one or more electrically operable label devices (17) are connected to the one or more conductors (29) by means of connectors (31) which are brought into electrical contact with the one or more conductors (29) when the connectors (31) are inserted through slots (6) in the hollow support member (1).

8. A method as claimed in claim 6, wherein data is supplied within the interior of the hollow support member (1) by utilizing the interior of the hollow support member (1) as a wave guide by providing a transceiver at one end of the hollow support member (1), the one or more electrically operable label devices (17) being supplied with data by means of connectors each having a cooperable transceiver which is positioned within the interior of the hollow support member (1) when the connectors are inserted into the slots (6) in the hollow support member (1).

9. A shelving system having connection apparatus as claimed in any one of claims 1 to 5.
